# EUROPEAN PATENT APPLICATION

(11) **EP 2 790 286 A1**
(43) Date of publication of application: **15.10.2014**
(21) Application number: 13001500.1
(22) Date of filing: 22.03.2013
(51) Int. Cl.: H02J 1/00, G06F 1/30, H02J 1/10

(54) **Switchgear assembly, DC power distribution system, DC power distribution board**

(71) Applicant: ABB AG, 68309 Mannheim (DE)
(72) Inventor: Schärer, André, 5103 Möriken (CH); Merkel, Hans-Peter Dipl.-Ing., 69198 Schriesheim (DE); Forstbach, Matthias Dipl.-Ing., 64683 Einhausen (DE)

(57) **Abstract**

The invention relates to a DC power distribution system (12) for a switchgear assembly, in particular a low voltage switchgear assembly, for an AC/DC power conversion to supply DC power to a DC consumer load and in particular for a DC data center (50) and relates to a DC power distribution board (14, 45...48), whereas the DC power distribution system (12) comprises a modularized device arrangement comprising a DC power distribution board (14, 45...48) with a modularized power conversion unit (16, 51...54) with at least one rectifier and/or conversion device or converter (18) and at least one AC input and DC output terminal device (22,20), wherein an AC supply bus (24,70) on the input side as well as a DC supply bus (26,72) at the output side is provided and wherein the at least one DC power conversion unit and/or rectifier or conversion device is electrically connected to the AC supply bus and DC supply bus. Furthermore, the invention also relates to a switchgear assembly with at least one DC power distribution system (12).

## Description

The invention relates to a DC power distribution system for a switchgear assembly, in particular a low voltage switchgear assembly, providing power for a DC consumer load and in particular for a DC data center, whereas the power distribution system includes a modularized device arrangement comprising a DC power distribution board with a modularized power conversion unit, and at least one AC input- and DC output- terminal device and an AC-system supply bus on the input side as well as a DC system supply bus at the output side. Furthermore, the invention relates to a power distribution board and a low voltage switchgear assembly in particular for the energy distribution and or power supply for a DC data center.

Common electrical switchgear assemblies are predominantly designed using so-called withdrawable part technology and/ or modularized devices, like in ABB's MNS^{®} System the so called MNS^{®} (registered Trademark of the ABB Automation Products GmbH) cubicle, wherein almost all of the operating means and devices, in particular processing, control, measuring and switching devices are arranged on or in modularized withdrawable parts and/or said exchangeable cubicles.

This provides a simplified access in case of a fault or maintenance activities, because the module or cubicle in question can be removed easily from the housing and therefore checked, repaired, exchanged or replaced without any considerable dismantling work.

Common data center arrangements for switchgears are using separated standalone AC/AC UPS to ensure and secure a constant energy supply of said datacenter or any other AC consumer load.

According to this arrangement independent components and external cabling are provided to transfer the supply power from a medium voltage level to a reliable uninterrupted low voltage supply level on the server side for the server racks in the respective datacenter.

In particular this set-up comprises several independent components, in particular rectifiers, cabling and circuit breakers for line protection, which are electrically connected via cables to the input (medium voltage) side and the output (low voltage) side to transfer the power from medium voltage level to a reliable uninterrupted supply on the low voltage side for server racks in a datacenter, whereas each line has to be protected by a circuit line breaker or switch.

The disadvantage of such a system is the effort in engineering, commissioning and maintenance as well as the costs and the energy or thermal losses via the cabling and breakers. In the same way the system will increase the footprint and cost linear increases according to the increase of the required power. For datacenters starting from 1 MW power consumption this creates an enormous effort and costs.

Furthermore, with regard to data centers and in particular the known AC/AC UPS the direct current (DC) technology may significantly reduce power conversion and thermal losses and accordingly seem to be more energy efficient than traditional alternating current (AC) technology for electrical distribution in data centers. Advantageously DC systems are less complex and require less space. They allow reducing equipment, installation time and effort, real estate and maintenance effort.

A DC power distribution system may not solely increase the efficiency of the electrical infrastructure but also may increase the efficiency in the respective sever or IT room as well as in the data center and the switchgear itself, because thermal losses are reduced and accordingly less cooling is required. Moreover, the DC technology seems to be an ideal solution for data centers as it minimizes footprint, installation and maintenance effort and in particular costs, electrical and thermal losses, without sacrificing reliability.

According known UPS standalone arrangements and the external cabling a number of rectifier or converter devices have to be provided, wherein each converter device for each phase is electrically connected to a circuit breaker on the medium voltage supply side and with a circuit breaker on the low voltage supply side.

Disadvantageously such a system and arrangement, in particular according to its complexity and cabling as well as the relatively large number of components causes a higher or bigger effort in engineering, commissioning and maintenance as well as higher costs. In particular, in view of safeguarding against failure and redundancy aspects.

Therefore the object of the invention is to provide a DC power distribution system for a switchgear assembly, and in particular a low voltage switchgear assembly, ensuring a high flexibility and reliability with a reduced complexity and accordingly with lower installation and operational effort on a higher level of maintainability. Furthermore, also the energy consumption and the power dissipation (losses) shall be reduced and/or minimized to be relatively low to retrieve and provide a more efficient system.

This object is solved by a DC power distribution system for a switchgear assembly, in particular a low voltage switchgear assembly, providing power for a DC consumer load and in particular for a DC data center, whereas the power distribution system comprise a modularized device arrangement comprising a power distribution board with a modularized power conversion unit with at least one rectifier and/or conversion device or converter and at least one AC input and DC output terminal device, wherein an AC supply bus on the input side as well as a DC supply bus at the output side is provided and wherein the at least one DC power conversion unit and/or rectifier or conversion device is electrically connected to the AC supply bus and DC supply bus.

Further embodiments and refinements of the invention and in particular a power distribution board, a switchgear assembly and DC data center are disclosed in the further claims and the following description.

In a further embodiment of the invention the AC supply bus includes at least one AC system supply bus bar per phase, in particular arranged in a respective switchgear assembly..

In the context of this application a bus bar may be understood as any type of electrical conductor applicable to be used in a switchboard or switchgear assembly, not limited or restricted by a specific bar geometry.

In a further refinement the power distribution system for a switchgear and in particular for a low voltage switchgear assembly, according to the invention is designed and built as an integrated component and part of a switchgear and provides DC power for a DC consumer load, and in particular for a switchgear assembly in a DC data center.

In another embodiment the DC power distribution system comprises at least one power distribution board providing
○ at least one AC input terminal device and at least one DC output- terminal device
○ a modularized DC power conversion unit comprising
■ an AC input terminal on the AC input side,
■ a DC output terminal on the DC output side,
■ at least one converter and/or rectifier device which is electrically connected to the AC terminal with their AC input side and to the DC terminal with their DC output side,
■
and wherein at least one AC system bus bar per phase and at least one DC system bus bar per phase are provided and wherein one AC circuit breaker on the AC input side of the distribution board and one DC circuit breaker on the DC output side of the distribution board are provided, and wherein the input terminal of the modularized power conversion unit is electrically connectable or connected to the input terminal device on the AC side of the distribution board and wherein the output terminal of the modularized power conversion unit is electrically connectable or connected to the output terminal device on the DC side of the distribution board and wherein the input and output terminal devices are fixed, in particular hard bolded, to the power distribution board and are permanently connected to the respective AC system supply bus bars and DC system supply bus bars.
Furthermore, a switchgear assembly according to the invention is provided, which comprises an AC power source or supply connected to the at least one AC system supply bus bar and/or connected in series with the AC circuit breaker and the AC system supply bus bar.

In a further embodiment, the AC power source or power supply provides a general AC circuit breaker which may be integrated in the switchgear assembly. Furthermore, a DC consumer load, in particular a DC data center, is provided and electrically connected to the DC system bus bar via the DC circuit breaker and /or connected in series with the DC circuit breaker and the DC system supply bus bar.

In another embodiment each rectifier and/or converter of the power conversion unit comprises a DC input terminal and an integrated DC circuit breaker to be connected to a DC power source, in particular one or more batteries, in particular arranged in a battery cabinet and/or a switchgear assembly.

In a further refinement each of the rectifier devices and/or conversion devices and converter devices respectively of the modularized power conversion unit are electrically connected to at least one DC power supply or source, in particular one or more battery cabinets, to form or build an integrated UPS (Uninterruptable Power Supply), so that in a switchgear assembly, and in particular a low voltage switchgear assembly, DC power may be supplied to a DC consumer load and in particular to a DC data center even in case the AC power supply fails.

In the context of this application a UPS is a device which provides and maintains continuous power even in case the main power supply fails. The UPS usually is electrically connected between the main power source and the respective appliance, in particular the DC data center or any other DC consumer load. The UPS is capable of switching from main power to battery supply whenever the main power supply fails.

In another embodiment the modularized power conversion unit is designed as an AC/DC power conversion cubicle or withdrawable part or module for a switchgear assembly.

Furthermore, in one embodiment the power conversion unit and/or the DC data center or DC consumer load are arranged in one or more withdrawable parts or modules or cubicles of an electrical switchgear assembly and /or are capable of being integrated in the switchgear assembly.

Advantageously a power distribution system with a power distribution board with a bus bar arrangement comprising at least one AC- and DC-bus bar allows a higher flexibility and reliability with lower investment and operational costs on a higher level of maintainability and reduced power losses.

In another refinement the power conversion unit and at least each rectifier device or power conversion device comprises a DC regulated output and/or output terminal to the internal DC supply bus bar and/or the DC system bus bar to feed the respective DC data center or any other DC consumer load.

In a further refinement the a floating ground system is provided, in particular provided by the power conversion unit and/or the DC output, which allows highest reliability as even the first ground fault will not cause a system shut down.

In a further embodiment an earth fault supervision system is provided, which in cooperation with a floating ground system provides and allows an identification of a fault area and/or allows maintenance activities and repairs, even on line.

In a further embodiment the power conversion unit comprises at least one AC/DC converter device or rectifier device based on an AFE (Active Front End), in particular a 3 level AFE (Active Front End) and a buck converter, in particular a 3 level buck converter with a connection to a battery string, in particular on a 750VDC internal DC level.

Furthermore, a power conversion unit may be provided, wherein each rectifier device or conversion device is set up or built as a dedicated power module, in particular a 300kW module and/or wherein all the provided devices are electrically connected in a parallel connection.

In another embodiment of an exemplary DC power distribution system the general AC circuit breaker is arranged in a withdrawable part or module or cubicle and electrically connected in line or in series with the AC system bus bar between the AC power supply and the power conversion unit and/or AC input terminal device of the power distribution board.

Furthermore, in another embodiment an AC/AC converter module to be mounted inside a switchgear slide-in module or a MNS cubicle or withdrawable part is provided.

In another embodiment an integrated LVAC (low voltage amplifying current) input combined with a AC/DC converter with battery string connection and DC regulated output to feed the datacenter is provided.

Furthermore a DC output will provide a floating ground system which allows highest reliability as even the first ground fault will not cause a system shut down.

In another embodiment of the switchgear assembly according to the invention, two or more power distribution systems are provided, wherein based on the modularity of the system and the 2N set-up, which in deed means full redundancy of the system, the switchgear assembly and the respective DC consumer load, in particular the DC data center will be or stay in operation even with one complete rectifier string fails or is shut down for maintenance.

Advantageously a bypass is not required as the DC distribution system of the switchgear assembly is or may stay online all the time.

In a further embodiment in combination/cooperation with a floating ground system an earth fault supervision system may be provided which will indicate the respective ground fault and allows an identification of the respective fault area and allows reparation or repairing it even on line.

The integration disclosed above allows a smaller footprint with even higher efficiency due to increasing power.

The integrated DC power distribution and/or UPS system according to the invention will avoid additional breakers for any required line protection in a stand-alone system.

Furthermore, according to another exemplary embodiment of the invention, the switchgear assembly and in particular the power distribution system comprises an HMI (Human Machine Interface) to display system status information.

Furthermore, the invention relates to a switchgear assembly, in particular for a DC data center, comprising at least one power distribution system and/or at least one integrated UPS as disclosed above.

Moreover, a DC data center is disclosed and claimed comprising at least one switchgear assembly providing at least one power distribution system and/or at least one integrated UPS according to one of the above disclosed embodiments.

These and further embodiments and improvements of the invention are subject matter of the sub-claims and of the further description.

By means of an exemplary embodiment shown in the accompanied drawing the invention itself, preferred embodiments and improvements of the invention and specific advantages of the invention shall be explained and illustrated in more detail.

It is shown in
Fig. 1 an exemplary embodiment of a switchgear assembly according to the invention comprising an integrated power distribution / UPS system,
Fig. 2 a,b circuit diagram of an exemplary converter or conversion device used in a power conversion unit according to the invention,
Fig. 3 an exemplary embodiment of a DC data center comprising a switchgear assembly with four DC power conversion units according to the invention

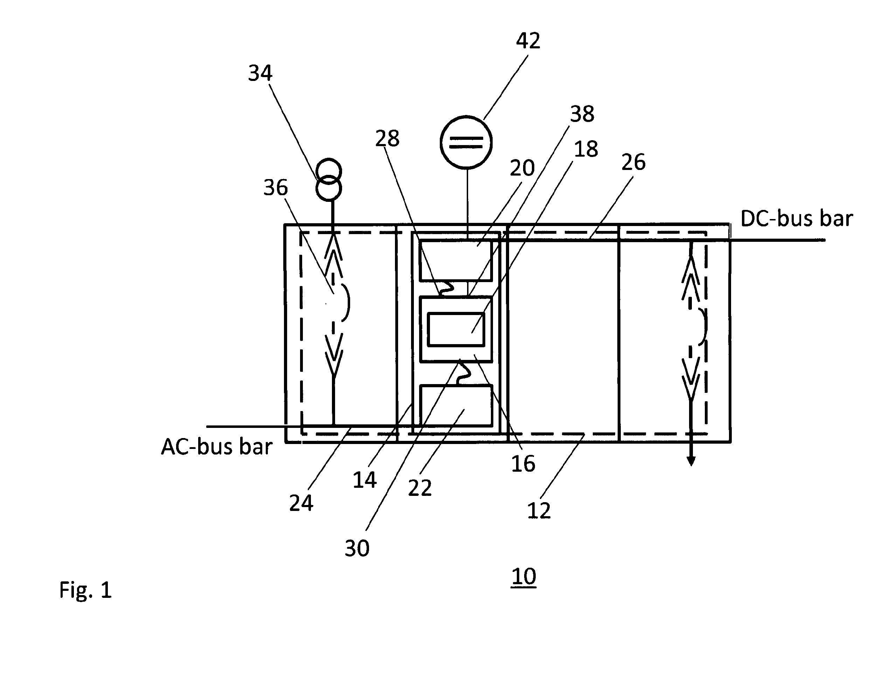

In Fig. 1 an exemplary embodiment of a switchgear assembly according to the invention is disclosed.
The switchgear assembly 10 comprises a power distribution system 12 for a switchgear assembly 10, in particular a low voltage switchgear assembly, providing power for a DC consumer load and in particular for a DC data center, whereas the power distribution system 12 comprise a modularized device arrangement comprising a power distribution board 14 with a modularized power conversion unit 16 with at least one rectifier and/or conversion device or converter device 18 and at least one AC input- 22 and DC output-20 terminal device, wherein an AC-supply bus 24 on the input side as well as a DC supply bus 26 at the output side is provided and wherein the at least one rectifier or conversion or converter device 18 is electrically connected to the AC supply bus 24 and DC supply bus 26.

The AC supply bus according to this example includes at least one AC system supply bus bar per phase, wherein in the context of this application a bus bar may be understood as any type of electrical conductor applicable to be used in a switchboard or switchgear assembly and not limited to or restricted by a specific geometry.

A bus bar may also comprise an electrical conductor bundle or conductor assembly.

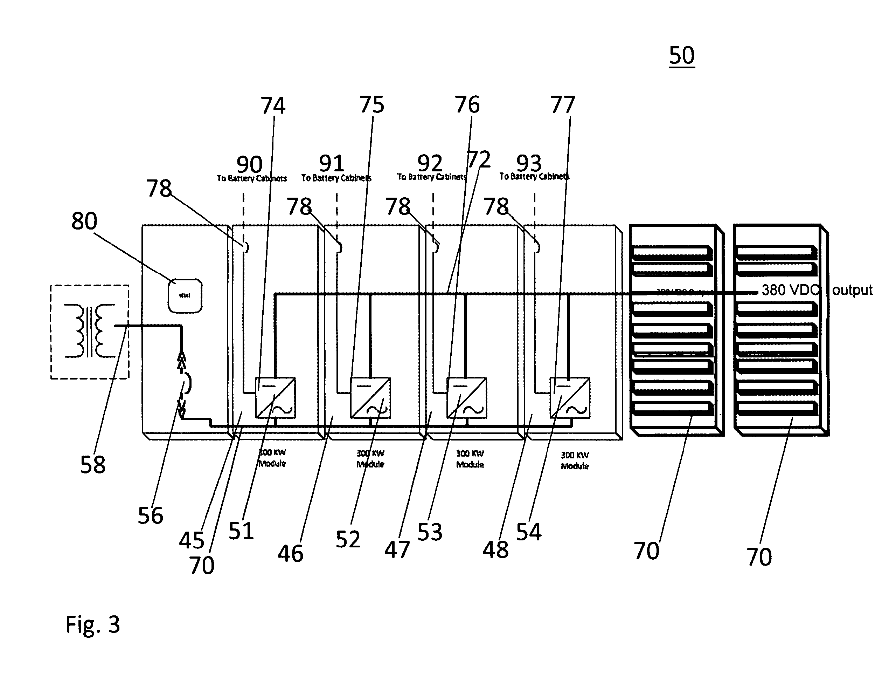

The DC power distribution system 12 for a switchgear and in particular for a low voltage switchgear assembly, according to the example of fig. 1 is designed and built as an integrated component and part of at least one switchgear or switchgear assembly and provides DC power for a DC consumer load, and in particular for a switchgear assembly 50 in a DC data center 52 (see fig. 3).

Furthermore, the DC power distribution system 12 comprises a power distribution board 14 providing an AC input terminal device 22 and a DC output- terminal device 20. A modularized power conversion unit 16 is provided comprising an AC input terminal 28 on the AC input side and a DC output terminal 30 on the DC output side. The converter device 18 and/or rectifier device is electrically connected to the AC terminal 30 with its AC input side and to the DC terminal 28 with its DC output side.

The AC system bus comprises a bus bar per phase, wherein according to simplification reasons only one of three AC phases and accordingly only one AC bus bar 24 is disclosed in fig. 1. The DC system bus also comprises one bus bar per phase, wherein according to simplification reasons only one of two DC phases and accordingly only one DC bus bar 26 is disclosed in fig. 1.

Moreover, an AC circuit breaker is provided on the AC input side of the distribution board 14 and one DC circuit breaker is provided on the DC output side of the distribution board 14, and wherein the input terminal 30 of the modularized power conversion unit 16 is electrically connectable or connected to the input terminal device 22 on the AC side of the distribution board 14 and wherein the output terminal 28 of the modularized power conversion unit 16 is electrically connectable or connected to the output terminal device 20 on the DC side of the distribution board 14 and wherein the input and output terminal devices 20,22 are fixed, in particular hard bolded, to the power distribution board 14 and are permanently connected to the respective AC system supply bus bars 24 and DC system supply bus bars 26.

In an exemplary embodiment the AC- and DC circuit may be integrated in or part of the respective terminal device 20,22.

The switchgear assembly disclosed in fig. 1 comprises an AC power source or power supply 34 connected to the at least one AC system supply bus bar 24 and/or connected in series with a general AC circuit breaker 36 and the AC system supply bus bar 24.

The general AC circuit breaker 36 may be integrated in the switchgear assembly 10.

The power conversion unit 16 comprises a DC input terminal 38 and an integrated DC circuit breaker to be connected to a DC power source 42, in particular one or more batteries or a battery series, in particular arranged in a battery cabinet and/or a switchgear assembly.

Accordingly, in particular in operation or operational condition, each of the rectifier devices and/or conversion devices or converter devices 18 of the modularized power conversion unit 16 are electrically connected to at least one DC power supply or source 42, in particular one or more battery cabinets and/or battery series, to form or build an integrated UPS (Uninterruptable Power Supply), so that in a switchgear assembly, and in particular a low voltage switchgear assembly, DC power may be supplied to a DC consumer load and in particular to a DC data center even in case the AC power supply fails.

As an exemplary refinement the modularized power conversion unit 18 may be designed and/or built as an AC/DC power conversion cubicle or module or withdrawable part for a switchgear assembly 10, insertable and/or integrable in said switchgear assembly 10 and/or attachable to the DC power distribution board 14.

Advantageously the disclosed DC power distribution system with a power distribution board 14 with a bus bar arrangement comprising at least one AC- and DC-bus bar 24,26 allows a higher flexibility and reliability with lower investment and operational costs on a higher level of maintainability and reduced power losses.

In a further refinement a DC regulated output and/or output terminal to the the DC system bus bar 26 is provided to feed the respective DC data center or any other DC consumer load, in particular with a regulated and controlled DC power. Furthermore, a floating ground system and/or an earth fault supervision system may be provided, in particular provided by the power conversion unit and/or the DC output, which allows highest reliability, and/or provides identification means to identify a fault area and/or allows maintenance activities and repairs, even on line.

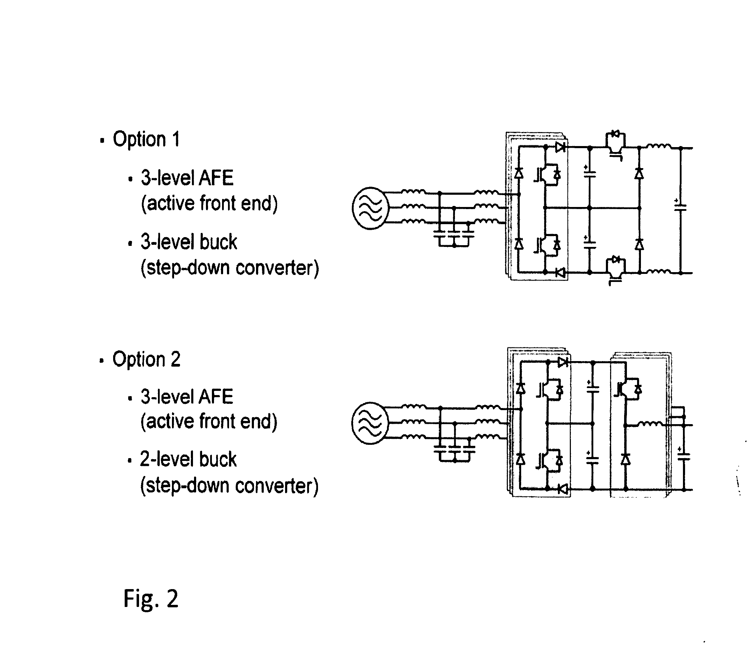

As disclosed in fig. 2 an exemplary power conversion unit comprises at least one AC/DC converter device or rectifier device based on an AFE (Active Front End) and a buck converter, wherein according to option 1 a 3 level AFE (Active Front End) and a 3 level buck converter is provided and wherein according to option 2 with a 3 level AFE (Active Front End) and a 2 level buck converter is provided. Moreover, a connection to a DC source battery string, in particular on a 750VDC internal DC level may be provided.
In figure 3 a DC data center 50 is disclosed comprising a switchgear assembly including a DC power distribution system comprising four DC power distribution boards, each equipped with a DC power conversion unit 51,52,53,54, wherein each power conversion unit 51,52,53,54 is designed or set up or built as a dedicated 300 KW power module or cubicle, and wherein all the provided units are electrically connected in a parallel connection.

According to fig. 3 a DC power distribution system is provided comprising four DC power distribution boards 45,46,47,48, wherein each board may be located or arranged in a switchgear and/or a switchgear cabinet, and wherein each board provides an exchangeable AC/DC power conversion unit 51,52,53,54 that comprises at least one rectifier and/or conversion and/or converter device. The individual converter or conversion unit 51,52,53,54 and the comprised devices are arranged in one module or cubicle, in particular an MNS cubicle of the switchgear assembly and are mountable and electrically connectable to the respective power distribution board.

At least one of the provided power distribution boards 45,46,47,48 provides
○ at least one AC input terminal device and at least one DC output terminal device,
○ a modularized power conversion unit 51,52,53,54 comprising
■ an AC input terminal and/or at least one internal AC supply bus bar on the AC input side,
■ a DC output terminal and/or at least one internal DC supply bus bar on the DC output side,
■ at least one converter and/or rectifier device which is electrically connected to the internal AC supply bus bar and/or the AC terminal with their AC input side and to the internal DC supply bus bar and/or the DC terminal with their DC output side.

Furthermore, at least one AC system bus bar 70 per phase and at least one DC system bus bar 72 per phase are provided and wherein one AC circuit breaker (not shown in fig. 3) on the AC input side of the respective distribution board and one DC circuit breaker (not shown in fig. 3) on the DC output side of the distribution board 45,46,47,48 are provided, and wherein the input terminal of the modularized DC power conversion unit 51,52,53,54 is electrically connectable or connected to the input terminal device on the AC side of the distribution board and wherein the output terminal of the modularized power conversion unit 51,52,53,54 is electrically connectable or connected to the output terminal device on the DC side of the distribution board and wherein the input and output terminal devices are fixed, in particular hard bolded, to the power distribution board 45,46,47,48 and are permanently connected to the respective AC system supply bus bars 70 and DC system supply bus bars 72.

Furthermore, an exemplary switchgear assembly according to the invention is presented, which comprises an AC power source or supply 58 connected to the at least one AC system supply bus bar 70 and/or connected in series with the general AC circuit breaker 56 and the AC system supply bus bar 70.

Each distribution board comprises an DC output terminal device as well as an AC input terminal device, wherein the terminal devices of the respective distribution board 45,46,47,48 each are "permanently" installed or fixed to the corresponding system supply bus bars 70,72.

Each power conversion unit 51,52,53,54 comprises a DC input terminal 74,75,76,77, whereas when the power conversion unit 51,52,53,54 is inserted into or fixed to its power distribution board its DC input terminal gets or is electrically connected to a battery cabinet and/or a battery string as DC power source to provide an integrated UPS system.
Furthermore, the individual DC input terminal 74,75,76,77 comprises an integrated DC circuit breaker 78 to be connected to a DC power source 90,91,92,93, in particular one or more batteries or a battery series, in particular arranged in a battery cabinet and/or a switchgear assembly.

Accordingly, in particular in operation or operational condition, each of the rectifier devices and/or conversion devices or converter devices 18 of the modularized power conversion unit 16 as well as the unit itself are electrically connected to at least one DC power supply or source 90,91,92,93, in particular one or more battery cabinets and/or battery series, to form or build an integrated UPS (Uninterruptable Power Supply), so that in a switchgear assembly, and in particular a low voltage switchgear assembly, DC power may be supplied to a DC consumer load and in particular to the server racks and/or data processing units of a DC data center 50 even in case the AC power supply fails.

Furthermore, the general AC circuit breaker 56 may be arranged in a withdrawable part or module or cubicle and electrically connected in line or in series with the AC system bus bar 70 between the AC power supply 58 and the respective DC power conversion unit 51,52,53,54 and/or AC input terminal device of the power distribution board.

Moreover, an integrated LVAC (low voltage amplifying current) input combined with a AC/DC converter with battery string connection 62,63,64,65 and DC regulated output to feed the DC datacenter 50 may be provided.

In one exemplary embodiment, based on the modularity of the disclosed power distribution system and the 2N set-up, which in deed means full redundancy of the power distribution system, the DC data center and the corresponding switchgear assembly will be or stay in operation even with one complete power conversion unit or rectifier string fails or is shut down for maintenance.

Advantageously a bypass is not required as the DC power distribution system of the disclosed DC data center is or may stay online all the time.

The integration disclosed above allows a smaller footprint of the DC data center 50 with even higher efficiency due to increasing power.

Furthermore, an HMI (Human Machine Interface) 80 is provided according to the disclosure of fig. 3 to display system status information.

According to the example of fig. 3 an output DC Voltage of 380VDC is provided as supply voltage for the server racks 70 and data processing units of the DC data center 50.

Next to the main line up with the AC incoming breaker and the AC/DC converter cubicles, the system allows the standard extension possibilities as known from MNS. In that way it is possible to connect the main and sub distribution on the DC part directly to the main bus bar system as well as to connect AC parts, like AC distribution for lighting or air-conditioning or an additional incoming section from a generator.

The present invention also comprises any combination of preferred embodiments as well as individual features and developments provided they do not exclude each other.

## Claims

1. DC Power distribution board (14,45...48) for a switchgear assembly for an AC/DC power conversion to supply DC power to a DC consumer load, comprising at least one AC input terminal device (22) and at least one DC output terminal device (24) and a modularized DC power conversion unit (16) comprising an AC input terminal (30) on the AC input side and a DC output terminal (28) on the DC output side and at least one converter and/or rectifier device (18) which is electrically connected to the AC input terminal (30) with its AC input side and to the DC output terminal (28) with their DC output side.

2. DC Power distribution(14,45...48) board according to claim 1, **characterized in that** the input terminal (30) of the modularized power conversion unit is electrically connectable or connected to the input terminal device (22) on the AC side of the distribution board (14) and wherein the output terminal (28) of the modularized power conversion unit (28) is electrically connectable or connected to the output terminal device (20) on the DC side of the distribution board and/or wherein the input (22) and output (20) terminal devices are fixed, in particular hard bolded, to the power distribution board (14) and/or wherein the AC input terminal device (22) is permanently connected to an AC system supply bus (24) and wherein the DC output terminal device (20) is permanently connected to a DC system supply bus (26).

3. DC power distribution board (14,45...48) according to one of the claims 1 to 2 **characterized in that** the power conversion unit (16) comprises a DC input terminal (74,75,76,77) and wherein a DC circuit breaker (78) to be connectable to a DC power source (90,91,92,93), in particular one or more batteries and/or a battery cabinet and/or a battery series.

4. DC power distribution board (14,45...48) according to one of the claims 1 to 3 **characterized in that** the modularized power conversion unit is designed as an AC/DC power conversion cubicle or withdrawable part or module for a switchgear assembly.

5. DC power distribution system (12) for a switchgear assembly, in particular a low voltage switchgear assembly, for an AC/DC power conversion to supply DC power to a DC consumer load and in particular for a DC data center, whereas the power distribution system (12) comprises a modularized device arrangement comprising at least one DC power distribution board (14, 45...48) with a modularized power conversion unit (16,51...54) with at least one rectifier and/or conversion device or converter (18) and at least one AC input (and DC output terminal device (22,20), wherein an AC supply bus (24,70) on the input side as well as a DC supply bus (26,72) at the output side is provided and wherein the at least one rectifier or conversion device (18) is electrically connected to the AC supply bus (24,70) and DC supply bus (26,72).

6. DC power distribution system (12) for a switchgear assembly according to claim 5, **characterized in that** the AC supply bus (24,70) includes at least one AC system supply bus bar per phase, in particular three phases, and/or wherein the DC supply bus (26,72) includes at least one DC system supply bus bar per phase, in particular two phases.

7. DC power distribution system (12) for a switchgear assembly according to claim 5 or 6, **characterized in that** it is designed and built as an integrated component and part of a switchgear.

8. DC power distribution system (12) for a switchgear assembly according to one of the claims 5 to 7, **characterized in that** it comprises at least one power distribution board (14,45...48) according to one of claims 1 to 4, wherein at least one AC system bus bar per phase and at least one DC system bus bar per phase are provided and wherein for each power distribution board (14, 45...48) an AC circuit breaker on the AC input side of the distribution board (14, 45...48) and a DC circuit breaker on the DC output side of the distribution board (14, 45...48) are provided, and wherein the input terminal (30) of the modularized DC power conversion unit (16,51...54) is electrically connectable or connected to the input terminal device (22) on the AC side of the distribution board and wherein the output terminal (28) of the modularized power conversion (16, 51...54) unit is electrically connectable or connected to the output terminal device (28) on the DC side of the distribution board (14, 45...48) and/or wherein the input and output terminal devices (22,20) are fixed, in particular hard bolded, to the power distribution board (14, 45...48) and/or are permanently connected to the respective AC system supply bus bars and DC system supply bus bars.

9. DC power distribution system (12) according to one of the claims 5 to 8, **characterized in that** an AC power source (34,58) or supply is connected to the at least one AC system supply bus bar (24,70) and/or connected in series with an AC circuit breaker and the AC system supply bus bar.

10. DC power distribution system (12) according to one of the claims 5 to 9, **characterized in that** the DC power conversion unit (16, 51...54) comprises a DC input terminal (74...77) and an integrated DC circuit breaker (78) to be connected to a DC power source (42,90...93), in particular one or more batteries and/or a battery cabinet and/or a battery series.

11. DC power distribution system (12) according to one of the claims 5 to 10, **characterized in that** the modularized DC power conversion unit (16, 51...54) and/or the rectifier devices and/or conversion devices and converter devices (18) respectively of the modularized power conversion unit are electrically connected to at least one DC power supply or source(42, 90...93), in particular one or more battery cabinets, to form or build an integrated UPS.

12. Switchgear assembly comprising at least one DC power distribution system (10) according to one of the claims 5 to 11.

13. Switchgear assembly according to claim 12, **characterized in that** an AC power source or power supply (34,58) and a general AC circuit breaker (36,56) are provided and/or wherein the general circuit breaker is integrated in the switchgear assembly.

14. Switchgear assembly according to claim 12 or 13, **characterized in that** a DC consumer load (70) is electrically connected to the DC system bus bar via the DC circuit breaker and /or connected in series with the DC circuit breaker and the DC system supply bus bar(26,72).

15. DC data center (50) comprising at least one switchgear assembly according to one of the claims 12 to 14 and/or comprising at least one DC power distribution system according to one of the claims 5 to 11.
